# EUROPEAN PATENT APPLICATION

(11) **EP 1 011 195 A2**
(43) Date of publication of application: **21.06.2000**
(21) Application number: 99124679.4
(22) Date of filing: 10.12.1999
(51) Int. Cl.: H03G 3/30

(54) **Variable attenuator system for controlling level of received signal in VSAT**

(30) Priority: 10.12.1998 JP 35171298
(71) Applicant: NEC CORPORATION, Tokyo (JP)
(72) Inventor: Yagawa, Kenichiro, c/o NEC Corporation, Tokyo (JP)
(74) Representative: Glawe, Delfs, Moll & Partner

(57) **Abstract**

A variable attenuator system comprises a variable attenuator which attenuates a received signal S_{RX} before conversion into a reception IF signal at an outdoor unit. A control unit is located in the outdoor unit and controls the variable attenuator to change an attenuation rate in response to control data. An operation unit is located in an indoor unit, which is distant form the outdoor unit and connected to the outdoor unit through an IF cable, and produces the control data. The operation unit modulates a control carrier wave with the control data to produce a control IF signal and to transmits the control IF signal to the control unit through the IF cable. The control unit demodulates the control data from the control IF signal.

## Description

### BACKGROUND OF THE INVENTION:

This invention relates to a variable attenuator system used for controlling a level of a received signal in a radio communication apparatus, such as a VSAT (Very Small Aperture Terminal), particularly, relates to a variable attenuator system capable of changing attenuation rate by remote control.

A conventional VSAT has an antenna located in the open air. The antenna is, for example, a parabolic antenna and receives radio signals, such as microwave signals, and produces a received signal. An outdoor unit is located near the antenna and connected to the antenna to convert the received signal into a reception IF (Intermediate Frequency) signal. An indoor unit is located away from the outdoor unit and connected to the outdoor unit with an IF cable. The indoor unit is supplied with the reception IF signal from the outdoor unit through the IF cable. The indoor unit demodulates or detects a desired signal from the reception IF signal.

Recently, owing to the increase in the number of both channels and artificial satellites for data communications and telecommunications, a level of the received signal tends to become very high. As the level of the received signal becomes high, the desired signal becomes modulated with an undesired signal included in the radio signals (or the received signal). Namely, cross modulation between the desired signal and the undesired signal is caused by the very high level of the received signal. As a result, receiving efficiency of the VSAT remarkably deteriorates.

Though the indoor unit has a level regulator for regulating a level of the reception IF signal, the level regulator can not remove the cross modulation.

By the way, it is known that a wave absorber is attached to a horn antenna so as to change a directivity characteristic thereof. Such a technique is disclosed in each of Japanese Unexamined Patent Publication (JP-A) No. 63-76602 (76602/1988), Japanese Examined Utility Model Publication (JP-Y2) 63-20181, and Japanese Examined Patent Publication (JP-B2) No. 63-58401 (58401/1988).

However, the wave absorber attached to the horn antenna can not attenuate a received signal received by an antenna and can not prevent from appearance of cross modulation between a desired signal and an undesired signal.

Moreover, it is known that a variable attenuator, such as a variable waveguide attenuator, is used for attenuating electromagnetic waves.

However, the variable attenuator has not been used for preventing from appearance of cross modulation between a desired signal and an undesired signal. In addition, it has not known to control the variable attenuator by remote control.

### SUMMARY OF THE INVENTION:

It is therefore an object of this invention to provide a variable attenuator system which can control a level of a received signal supplied from an antenna to an outdoor unit.

It is another object of this invention to provide a variable attenuator system which can attenuate a received signal supplied from an antenna to an outdoor unit.

It is still another object of this invention to provide a variable attenuator system which can prevent cross modulation between a desired signal and an undesired signal included in a received signal.

It is still further object of this invention to provide a variable attenuator system which can be controlled by remote control.

Other object of this invention will become clear as the description proceeds.

On describing the gist of this invention, it is possible to understand that a variable attenuator system is used in a radio communication apparatus which has an outdoor unit and an indoor unit connected to the outdoor unit through an IF cable. The outdoor unit converts a received signal into a reception IF signal. The indoor unit receives the reception IF signal through the IF cable.

According to the gist of this invention, the variable attenuator system comprises a variable attenuator which is located in the outdoor unit and attenuates the received signal. An operation unit is located in the indoor unit and produces control data. A control unit is located in the outdoor unit and connected to the variable attenuator and to the operation unit through the IF cable and controls the variable attenuator to change an attenuation rate of the received signal according to the control data.

According to another gist of this invention, a communication apparatus has an outdoor unit and an indoor unit. The outdoor unit has a mixer and produces a reception IF signal from a received signal. A method of controlling a level of the received signal comprises the steps of producing control data at the indoor unit, transmitting the control data from the indoor unit to the outdoor unit, and changing an attenuation rate of a variable attenuator, which attenuates the received signal, according to the control data.

According to still another gist of this invention, a variable attenuator is used in a radio communication apparatus which has a coupler and an electromagnetic born. The coupler radiates a received signal supplied from an antenna. The electromagnetic horn faces the coupler to receive the received signal radiated by the coupler. The variable attenuator comprises a movable wave absorber located between the coupler and the electromagnetic horn to partially absorb the received signal. A moving device is coupled to the wave absorber and moves the wave absorber to change an attenuation rate of the received signal travelling from the coupler to the electromagnetic horn.

According to further still another gist of this invention, a variable attenuator is located between an antenna and an outdoor unit of a radio communication apparatus. The antenna receives radio signals and produces a received signal. The outdoor unit produces an IF signal according to the received signal. The variable attenuator comprises a coupler which radiates the received signal. An electromagnetic horn faces to the coupler for receiving the received signal radiated by the coupler. A movable wave absorber is located between the coupler and the electromagnetic horn to partially absorb the received signal which travels from the coupler to the electromagnetic horn. A moving device is coupled to the wave absorber and moves the wave absorber to change an attenuation rate of the received signal travelling from the coupler to the electromagnetic horn.

### BRIEF DESCRIPTION OF THE DRAWING:

Fig. 1 is a block diagram of a radio communication apparatus having a variable attenuator system according to a preferred embodiment of this invention;
Fig. 2 is a block diagram of an outdoor unit of the radio communication apparatus of Fig. 1;
Fig. 3 is a block diagram of an indoor unit of the radio communication apparatus of Fig. 1; and
Fig. 4 is a block diagram of variable attenuator of the variable attenuator system included in the radio communication apparatus of Fig. 1.

### DESCRIPTION OF THE PREFERRED EMBODIMENT:

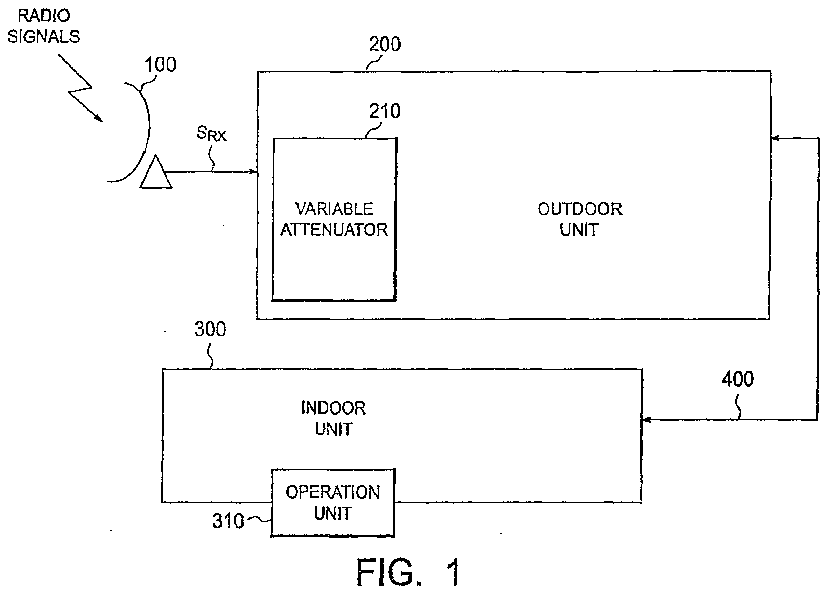

Referring to Figs. 1 through 4, the description will be made about a radio communication apparatus that includes a variable attenuator system according to a preferred embodiment of this invention.

In Fig. 1, the radio communication apparatus comprises an antenna 100 which receives radio signals to produce a received signal S_{RX}. For example, the antenna 100 is a parabolic antenna and the radio signals are microwave signals. The radio signals include a desired signal and an undesired signal. An outdoor unit 200 has a variable attenuator 210 that is connected to the antenna 100 and supplied with the received signal S_{RX} from the antenna 100. The outdoor unit 200 converts the received signal S_{RX} into a reception IF (Intermediate Frequency) signal. An indoor unit 300 is connected to the outdoor unit 200 through an IF cable 400 and has an operation unit 310. The indoor unit 300 is supplied with the reception IF signal S_{RIF} from the outdoor unit 200 Through the IF cable 400 and detects or demodulates the desired signal from the reception IF signal S_{RIF}.

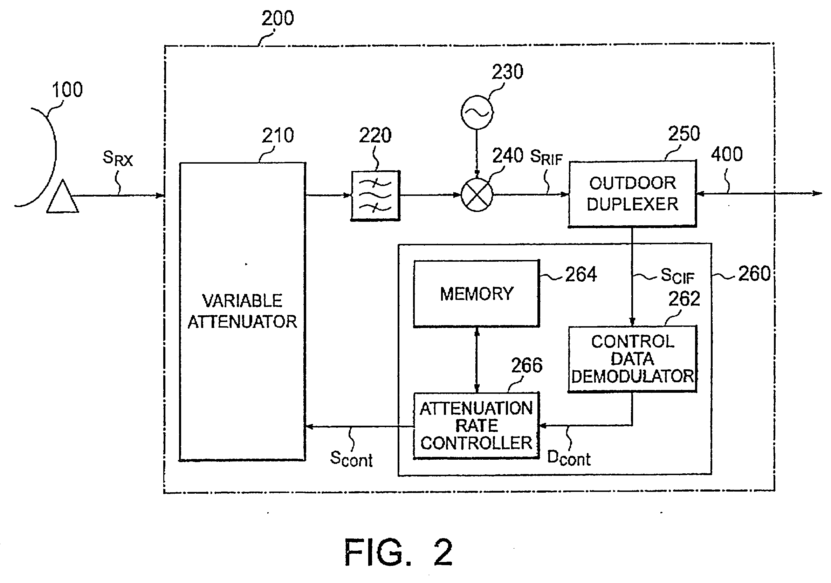

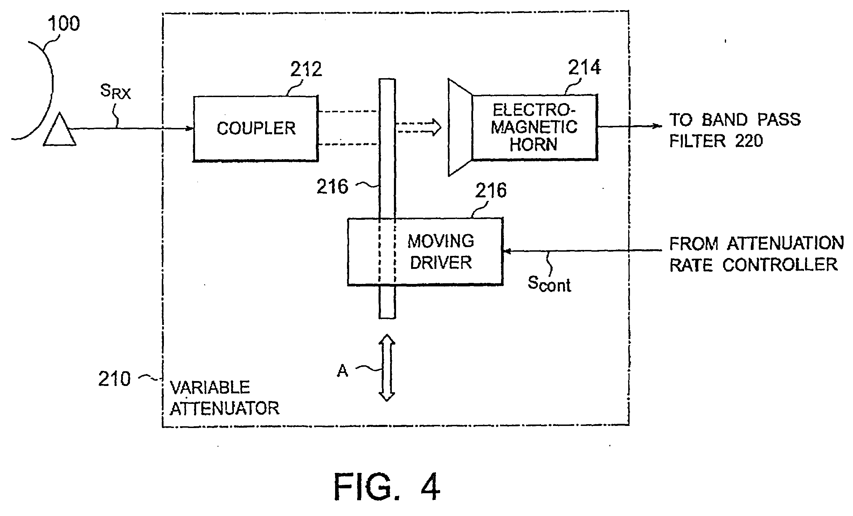

Referring to Fig. 2, the outdoor unit 200 includes a band pass filter 220 connected to the variable attenuator 210. The band pass filter 220 is supplied with the received signal S_{RX} from the variable attenuator 210 and filters the received signal S_{RX} to produce a filtered signal. Though the variable attenuator 210 will be described after in more detail with referring to Fig. 4, the received signal S_{RX} may be attenuated by the variable attenuator 210. A local oscillator 230 produces a local oscillation signal. A mixer 240 is connected to the band pass filter 220 and the local oscillator 230 and mixes the filtered signal with the local oscillation signal to produce the reception IF signal S_{RIF}. An outdoor duplexer 250 is connected to the mixer 240 and the IF cable 400 and transmits the reception IF signal S_{RIF} into the IF cable 400. The outdoor duplexer 250 comprises, for example, a matching circuit (not shown) and band pass filters (not shown). A control unit 260 is connected to the outdoor duplexer 250 and the variable attenuator 210 and has a control data demodulator 262, a memory 264 and a attenuation rate controller 266. The control unit 260 will be described after in more detail.

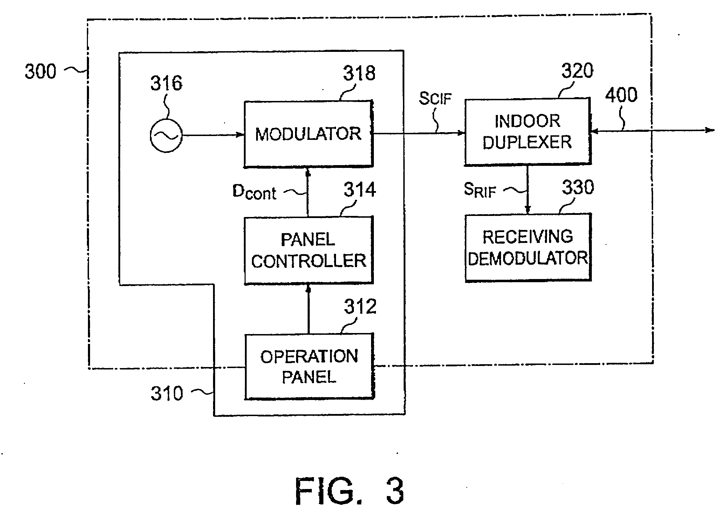

Referring to Fig. 3, the indoor unit 300 includes an indoor duplexer 320, which is connected to the IF cable 400, and a receiving demodulator 330, which is connected to the indoor duplexer 320. The indoor duplexer 320 is the same structure as the outdoor duplexer 250. The indoor duplexer 320 supplies the reception IF signal S_{RIF} from the If cable 400 to the demodulator 330. The receiving demodulator 330 demodulates the desired signal from the reception IF signal S_{RIF}.

The operation unit 310 comprises an operation panel 312 for which an operator gives commands to the variable attenuator system. A panel controller 314 is connected to the operation panel 312 and produces control data D_{CONT} representative of the commands. A control carrier oscillator 316 produces a control carrier wave. A modulator 318 is connected to the control carrier oscillator 316 and the panel controller 314 and modulates the control carrier wave with the control data D_{CONT} to produce a control IF signal S_{CIF}. For example, the modulator 318 uses a method of amplitude shift keying to modulate the control carrier wave. The indoor duplexer 320 supplies the control IF signal S_{CIF} from the modulator 318 to the IF cable 400.

Returning to Fig. 2, the control data demodulator 262 is connected to the outdoor duplexer 250 and supplied with the control IF signal S_{CIF} from the outdoor duplexer 250 to demodulate the control data D_{CONT}. The memory 264 memorizes a conversion table, which will be described after in more detail. The attenuation rate controller 266 is connected to the control data demodulator 262, the memory 264 and the variable attenuator 210 and produces a control signal S_{CONT} according to the control data D_{CONT} with referring to the conversion table.

Referring to Fig. 4, the variable attenuator 210 comprises a coupler 212 that is connected to the antenna 100 and emits the received signal S_{RX}. An electromagnetic horn 214 faces the coupler 212 at a distance and is connected to the band pass filter 220 to reproduce the received signal S_{RX} that is supplied to the band pass filter 220. A wave absorber 216 is located between the coupler 212 and the electromagnetic horn 214 to partially absorb the received signal S_{RX} travelling from the coupler 212 to the electromagnetic horn 214. A moving driver 216 is coupled with the wave absorber 216 and connected to the attenuation rate controller 266 to move the wave absorber 216 in response to the control signal S_{CONT}. For example, the moving driver 216 comprises a motor (not shown) having a motor shaft (not shown) a worm (not shown) fixed to the motor shaft, and a rack fixed to the wave absorber 216 and meshes with the worm.

The variable attenuator 210, the control unit 260 and the operation unit 310 forms the variable attenuator system.

Now, an operation of the radio communication apparatus is described below with referring to Figs. 2 to 4.

In Fig. 3, at first, when the operator gives the commands to the variable attenuator system from the operation panel 312, the operation panel 312 passes the commands to the panel controller 314. The commands represent attenuation rate of the received signal S_{RX} passed through the variable attenuator 210.

The panel controller 314 produces the control data D_{CONT} according to the commands and supplies the control data D_{CONT} to the modulator 318.

The modulator 318 modulates the control carrier wave supplied from the control carrier oscillator 316 with the control data D_{CONT} by the use of the amplitude shift keying method. The modulator 318 supplies the control IF signal S_{CIF} to the indoor duplexer 320.

The indoor duplexer 320 transmits the control IF signal S_{CIF} supplied from the modulator 318 into the IF cable 400.

In Fig. 2, the outdoor duplexer 250 passes the control IF signal S_{CIF} supplied through the IF cable 400 to the control data demodulator 262.

The control data demodulator 262 demodulates the control data D_{CONT} and supplies the control data D_{CONT} to the attenuation rate controller 266.

The attenuation rate controller 266 refers to the conversion table memorized in the memory 264 when it receives the control data D_{CONT}. The conversion table includes relationships between attenuation rates and control values, such as necessary moving distances or positions of the wave absorber 216. The attenuation rate controller 266 selects one of the necessary moving distances according to the control data D_{CONT}. and produces the control signal S_{CONT}, which represents the selected one of the necessary moving distances. The attenuation rate controller 266 supplies the control signal S_{CONT} to the moving driver 216.

In Fig. 4, the moving driver 216 moves the wave absorber along an arrow A in response the control signal S_{CONT}. In other words, the moving driver 216 moves the wave absorber in parallel to an aperture of the electromagnetic horn 214 for a distance represented by the control signal S_{CONT}. By moving of the wave absorber, power (or strength or amplitude) of the received signal S_{RX} arrived to the electromagnetic horn 214 is changed. That is, when the aperture is covered by the wave absorber and its area covered by the wave absorber becomes large, the received signal S_{RX} becomes weak. Therefore, the variable attenuator 210 changes the attenuation rate of the received signal S_{RX} and the reception level of the received signal S_{RX} changed thereby.

As mentioned above, the variable attenuator 210 can be easily controlled by remote control. The variable attenuator 210 is not influenced by the weather because it is not located at the antenna 100 but in the outdoor unit 200. Cross connection between the desired signal and the undesired signal is prevented by attenuating the received signal S_{RX} before the received signal SRX is converted into the reception IF signal.

While this invention has thus for been described in conjunction with the preferred embodiment thereof, it will readily be possible for those skilled in the art to put this invention into practice in various other manners. For example, the radio communication apparatus may have a transmitter. In this case, the wave absorber 216 must not have absorbing characteristics that it absorbs a transmitting signal produced by the transmitter. The absorbing characteristics are realized as mentioned below. For example, the wave absorber 216 absorbs signals of a frequency band used for the received signal S_{RX} but does not absorb signals a frequency band used for the transmitting signal. Moreover, the wave absorber 216 absorbs signals polarized along a direction but does not absorb signals polarized along another direction. Furthermore, the wave absorber 216 absorbs signals which advance in a direction but does not absorbs signals which advance in the reverse direction.

In addition, the variable attenuator 210 may be isolated from the outdoor unit 200.

## Claims

1. A variable attenuator system used in a radio communication apparatus having an outdoor unit and an indoor unit connected to said outdoor unit through an IF cable, said outdoor unit converting a received signal into a reception IF signal, said indoor unit receiving the reception IF signal through said IF cable, said variable attenuator system characterized by:
a variable attenuator located in said outdoor unit for attenuating the received signal;
an operation unit located in said indoor unit for producing control data; and
a control unit located in said outdoor unit and connected to said variable attenuator and to said operation unit through said IF cable for controlling said variable attenuator to change an attenuation rate of the received signal according to the control data.

2. A variable attenuator system as claimed in Claim 1, said control unit comprising a memory and a controller which is connected to said operation unit, said memory and said variable attenuator, wherein the variable attenuator system characterized in that:
said memory memorizes relationships between the control data and positions of said movable wave absorber;
said controller referring the relationships to control said variable attenuator.

3. A variable attenuator system as claimed in Claim 1, wherein the variable attenuator system characterized in that:
said operation unit comprises:
a control carrier wave oscillator for producing a control carrier wave;
a modulator for modulating the control carrier wave with the control data to produce a control IF signal; and
a first duplexer connected to said modulator and said IF cable for using said IF cable to receive the reception IF signal from said output unit and to transmit the control IF signal to said output unit;
said control unit comprising:
a second duplexer connected to the IF cable for using said IF cable to receive the control IF signal from said indoor unit and to transmit the reception IF signal to said indoor unit; and
a demodulator connected to said second duplexer for demodulating the control data from the control IF signal.

4. A variable attenuator system as claimed in Claim 3, wherein the variable attenuator system characterized in that said modulator modulates the control carrier wave by the method of amplitude modulation.

5. A variable attenuator system as claimed in Claim 1, wherein said variable attenuator characterized by:
a coupler for radiating the received signal;
an electromagnetic horn facing to said coupler for receiving the received signal;
a movable wave absorber located between said coupler and said electromagnetic horn for partially absorbing the received signal radiated from the coupler toward said electromagnetic horn; and
a moving device coupled to said wave absorber and connected to said control unit for moving said wave absorber to change the attenuation rate.

6. A method of controlling a level of a received signal of a communication apparatus having an outdoor unit and an indoor unit, said outdoor unit having a mixer to produce a reception IF signal from the received signal, the method characterized by the steps of:
producing control data at said indoor unit;
transmitting the control data from said indoor unit to said outdoor unit; and
changing an attenuation rate of a variable attenuator, which attenuates the received sinal, according to the control data.

7. A method as claimed in Claim 6, said outdoor unit having a memory which memorizes relationships between the control data and control values, wherein the method further characterized by the step of referring to the relationships before the utep of changing.

8. A method as claimed in Claim 6, wherein said method further characterized by the ateps of:
producing a control carrier wave at said indoor unit;
modulating the control carrier wave with the control data to produce a control IF signal at said indoor unit; and
demodulating the control data from the control IF signal at said outdoor unit.

9. A variable attenuator used in a radio communication apparatus which has a coupler and an electromagnetic horn, said coupler radiating a received signal supplied from an antenna, said electromagnetic horn facing said coupler to receive the received signal radiated by said coupler, said variable attenuator characterized by:
a movable wave absorber located between said coupler and said electromagnetic horn for partially absorbing the received signal; and
a moving device coupled to said wave absorber for moving said wave absorber to change an attenuation rate of the received signal travelling from said coupler to said electromagnetic horn.

10. A variable attenuator located between an antenna and an outdoor unit of a radio communication apparatus, said antenna receiving radio signals to produce a received signal, said outdoor unit producing an IF signal according to the received signal, said variable attenuator characterized by:
a coupler for radiating the received signal;
an electromagnetic horn facing to said coupler for receiving the received signal radiated by said coupler;
a movable wave absorber located between said coupler and said electromagnetic horn for partially absorbing the received signal which travels from said coupler to said electromagnetic horn; and
a moving device coupled to said wave absorber for moving said wave absorber to change an attenuation rate of the received signal travelling from said coupler to said electromagnetic horn.

11. A variable attenuator as claimed in Claim 5, 9 or 10, said electromagnetic horn having an aperture for facing to said coupler, wherein said variable attenuator characterize in that:
said moving device moves said movable wave absorber parallel with said aperture.

12. A variable attenuator as claimed in Claim 5, 9 or 10, wherein said variable attenuator characterized in that:
said movable wave absorber has different absorbing characteristics for radio wave signals having different frequencies, and/or
for radio wave sinals having different directions of polarization, and/or
for radio wave signals having different incidence angles.
